# EUROPEAN PATENT APPLICATION

(11) **EP 1 939 945 A2**
(43) Date of publication of application: **02.07.2008**
(21) Application number: 07016453.8
(22) Date of filing: 22.08.2007
(51) Int. Cl.: H01L 31/0392, H01L 21/461, H01L 21/302

(54) **Inverted metamorphic solar cell mounted on flexible film**

(30) Priority: 27.12.2006 US 616596
(71) Applicant: Emcore Corporation, Somerset, NJ 08873 (US)
(72) Inventor: Varghese, Tansen, Albuquerque NM 87123 (US); Cornfeld, Arthur, Albuquerque NM 87123 (US); Xie, Michelle, Albuquerque NM 87123 (US)
(74) Representative: Wagner, Karl H.

(57) **Abstract**

A method of manufacturing a solar cell on a flexible film by providing a substrate; depositing on the substrate a sequence of layers of semiconductor material forming a solar cell; mounting the semiconductor substrate on a flexible film; and thinning the semiconductor substrate to a predetermined thickness. The sequence of layers forms an inverted metamorphic solar cell structure.

## Description

### BACKGROUND OF THE INVENTION

### 1. Field of the Invention

The present invention relates to the field of solar cell semiconductor devices, and particularly to integrated semiconductor structures mounted on a flexible film including a multijunction solar cell and a via that allows both anode and cathode terminals to be accessed from the front side of the cell.

### 2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated, the design efficiency of solar cells, which act as the power conversion devices for the on-board power systems, become increasingly more important.

Solar cells are often fabricated in vertical, multijunction structures, and disposed in horizontal arrays, with the individual solar cell connected together in a series. The shape and structure of an array, as well as the number of cells it contains, are determined in part by the desired output voltage and current.

Inverted metamorphic solar cell structures such as described in U.S. Patent No. 6,951,819, M.W. Wanless et al., Lattice Mismatched Approaches for High Performance, III - V Photovoltaic Energy Converters (Conference Proceedings of the 31st IEEE Photovoltaic Specialists Conference, Jan. 3-7, 2005, IEEE Press, 2005) and copending U.S. Patent Application Serial No. 11/445,793 filed June 2, 2006, of the present assignee, present an important starting point for the development of future commercial products with high energy conversion efficiency.

Prior to the present invention, the materials and fabrication steps disclosed in the prior art have not been described for producing an energy efficient solar cell based on an inverted metamorphic structure mounted on a flexible film.

### SUMMARY OF THE INVENTION

Briefly, and in general terms, the present invention provides a method of manufacturing a solar cell by providing a substrate; depositing on the substrate a sequence of layers of semiconductor material forming a solar cell; mounting the substrate on a flexible film; and thinning the substrate to a predetermined thickness.

In another aspect briefly, and the general terms, the present invention provides a method of manufacturing a solar cell by adhering a first substrate to a flexible film support after depositing on the substrate a sequence of layers of semiconductor material to form at least one cell of a multijunction solar cell; and subsequently removing at least a portion of the first substrate.

The present invention further provides a solar cell mounted on a flexible film including a semiconductor body having a sequence of layers including a first solar subcell having a first band gap; a second solar subcell disposed over the first subcell and having a second band gap smaller than the first band gap; a grading interlayer disposed over the second subcell having a third band gap larger than the second band gap, and a third subcell disposed over the interlayer such that the third solar subcell is lattice mis-matched with respect to the second subcell and has a fourth band gap smaller than the third band gap.

### BRIEF DESCRIPTION OF THE DRAWINGS

These and other features and advantages of this invention will be better and more fully appreciated by reference to the following detailed description when considered in conjunction with the accompanying drawings, wherein:

FIG. 1 is an enlarged cross-sectional view of the solar cell according to the present invention at the end of the process steps of forming the layers of the solar cell on a first substrate;

FIG. 2 is a cross-sectional view of the solar cell of FIG. 1 after the next process step according to the present invention including adhering the structure to the top of a the flexible film;

FIG. 3 is a cross-sectional view of the structure of FIG. 2 after the next process step of adhering a surrogate substrate to the flexible film;

FIG. 4 is a cross-sectional view of the solar cell structure of FIG. 3 after the next process step according to the present invention depicted including removing the original substrate below the solar cell layers to leave a semiconductor structure;

FIG. 5 is a cross-sectional view of the solar cell of FIG. 4 after the next process step according to the present invention of removing a layer from the top of the semiconductor surface;

FIG. 6 is a cross-sectional view of the solar cell of FIG. 5 after the next process step according to the present invention in which another layer of the semiconductor surface is removed;

FIG. 7 is a cross-sectional view of the solar cell of FIG. 6 after the next process step according to the present invention in which a metal layer is deposited over the surface of the semiconductor surface.

FIG. 8 is a cross-sectional view of the solar cell of FIG. 7 after the next process step according to the present invention in which the metal layer is patterned into grid lines;

FIG. 9 is a cross-sectional view of the solar cell of FIG. 8 after the next process step according to the present invention in which the top layer of the semiconductor surface between the grid lines is removed;

FIG. 10 is a cross-sectional view of the solar cell of FIG. 9 after the next process step according to the present invention in which an ARC layer is deposited over the surface;

FIG. 11 is a cross-sectional view of the solar cell of FIG. 10 after the next process step according to the present invention in which bond pads are opened in the ARC layer;

FIG. 12 is a cross-sectional view of the solar cell of FIG. 11 after the next process step according to the present invention in which the surrogate substrate is removed.

### DESCRIPTION OF THE PREFERRED EMBODIMENT

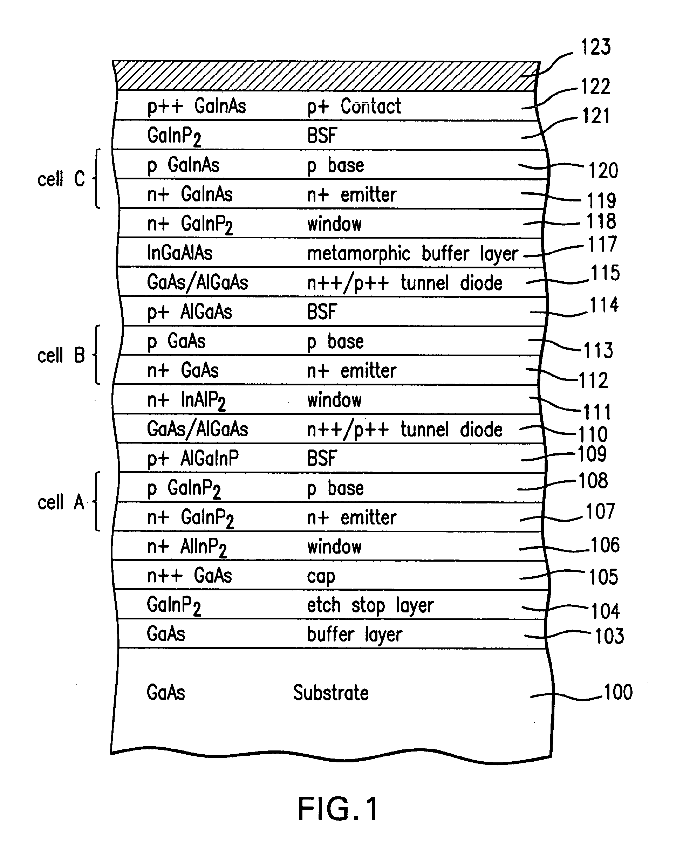

FIG. 1 depicts the multijunction solar cell according to the present invention after formation of the three subcells A, B and C on a substrate. More particularly, there is shown a first substrate 100, which may be either gallium arsenide (GaAs), germanium (Ge), or other suitable material. In the case of a Ge substrate, a nucleation layer such as InGaP₂, is deposited on the substrate. On the substrate, or over the nucleation layer in the case of a Ge substrate, a buffer layer 103 of GaAs, and an etch stop layer 104 of GaInP₂ are further deposited. A cap or contact layer 105 of n++ GaAs is then deposited on layer 104, and a window layer 106 of n+ AlInP₂ is deposited on the cap or contact layer 105. The subcell A, consisting of an n+ emitter layer 107 of GaInP₂ and a p type base layer 108 of GaInP₂, is then deposited on the window layer 106.

Although the preferred embodiment utilizes the III-V semiconductor materials described above, the embodiment is only illustrative, and it should be noted that the multijunction solar cell structure could be formed by any suitable combination of group III to V elements listed in the periodic table subject to lattice constant and band gap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In the preferred embodiment, the substrate 100 is gallium arsenide, the emitter layer 107 is composed of InGa(Al)P, and the base layer is composed of InGa(Al)P. The Al term in parenthesis means that Al is an optional constituent, and in this instance may be used in an amount ranging from 0% to 30%.

On top of the base layer 108 is deposited a p+ type back surface field ("BSF") layer 109 of AlGaInP which is used to reduce recombination loss.

The BSF layer 109 drives minority carriers from the region near the base/BSF interface surface to minimize the effect of recombination loss. In other words, a BSF layer 109 reduces recombination loss at the backside of the solar subcell A and thereby reduces the recombination in the base.

On top of the BSF layer 109 is deposited a sequence of heavily doped p-type (such as AlGaAs) and n-type layers 110 (such as InGaP₂) which forms a tunnel diode, which is used as a circuit element to electrically connect cell A to cell B.

On top of the tunnel diode layers 110 a window layer 111 of n+ InAlP₂ is deposited. The window layer 111 used in the subcell B also operates to reduce the recombination loss. The window layer 111 improves the passivation of the cell surface of the underlying junctions. It should be apparent to one skilled in the art, that additional layer(s) may be added or deleted in the cell structure without departing from the scope of the present invention.

On top of the window layer 111 the layers of cell B are deposited: the n+ emitter layer 112, and the p-type base layer 113. These layers are preferably composed of n+ GaAs and p type GaAs respectively, although any other suitable materials consistent with lattice constant and band gap requirements may be used as well.

On top of the cell B is deposited a BSF layer 114 of p+ type AlGaAs which performs the same function as the BSF layer 109. A n++/p++ tunnel diode 115 is then deposited over the BSF layer 114 similar to the tunnel diode of layers 110, again forming a circuit element to electrically connect cell B to cell C. The tunnel diode is preferably a layer of GaAs over a layer of AlGaAs. A metamorphic buffer layer 117 is then deposited over the tunnel diode 116. The layer 117 is preferably a compositionally step-graded composition of InGaAlAs deposited as a series of layers with monotonically changing lattice constant that provides a transition in lattice constant from cell B to subcell C. The bandgap of layer 117 is 1.5 eV constant with a value slightly greater than the bandgap of the middle cell B.

In one embodiment, as suggested in the Wanless et al. paper, the step grade contains nine compositionally graded steps with each step layer having a thickness of 0.25 micron. In the preferred embodiment, the interlayer is composed of InGaAlAs, with monotonically changing lattice constant.

On top of the metamorphic buffer layer 117 another n+ window layer 118 of GaInP₂ is deposited. The window layer 118 improves the passivation of the cell surface of the underlying junctions. Additional layers may be provided without departing from the scope of the present invention.

On top of the window layer 118 the layers of subcell C are deposited: the n+ type emitter layer 119 and the p type base layer 120. In the preferred embodiment, the emitter layer is composed of GaInAs and the base layer is composed of GaInAs with about a 1.0 eV bandgap, although any other semiconductor materials with suitable lattice constant and band gap requirements may be used as well.

On top of the base layer 120 of subcell C a back surface field (BSF) layer 121, preferably composed of GaInP₂, is deposited.

Over or on top of the BSF layer 121 is deposited a p+ contact layer 122, preferably of p++ type GaInAs.

On top of the p+ contact layer 122 is deposited a metal layer 123, preferably a Ti/Au/Ag/Au sequence of layers.

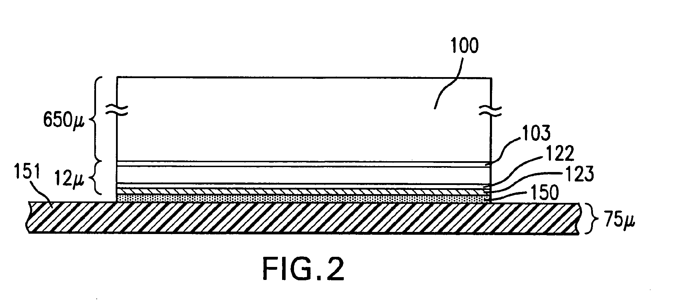

The semiconductor structure shown in FIG. 1 is then bonded to the surface of a flexible film 151 (such as Kapton) by an adhesive 150, as shown in FIG. 2. The flexible film typically has a thickness around 75 microns, while the semiconductor structure including substrate is around 660 microns. More particularly, the structure is bonded face down, i.e. with metal contact layer 123 being adjacent to the film 151.

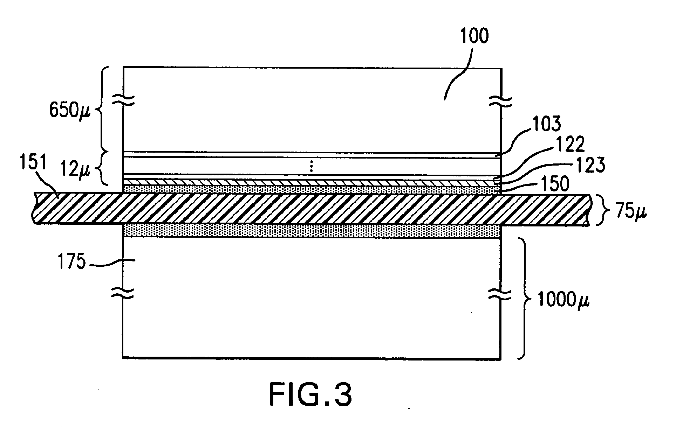

FIG. 3 is a cross-sectional view of the structure of FIG. 2 after the next process step of adhering a surrogate substrate 175 such as sapphire to the bottom of the flexible film 151. In the preferred embodiment, the surrogate substrate is about 1000 microns in thickness, and is perforated with holes about 1 mm in diameter, spaced 4 mm apart, to aid in subsequent removal of the substrate. The details of the adhering process, including a discussion of the choice of materials, will be subsequently discussed.

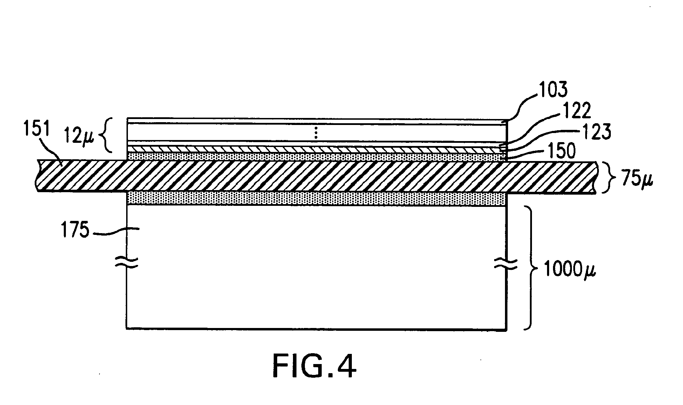

FIG. 4 is a cross-sectional view of the solar cell structure of FIG. 3 after the next process step according to the present invention depicted including removing the original substrate 100 below the solar cell layers 123 though 103 to leave a semiconductor structure consisting of layers 123 through 103 about 12 microns in thickness.

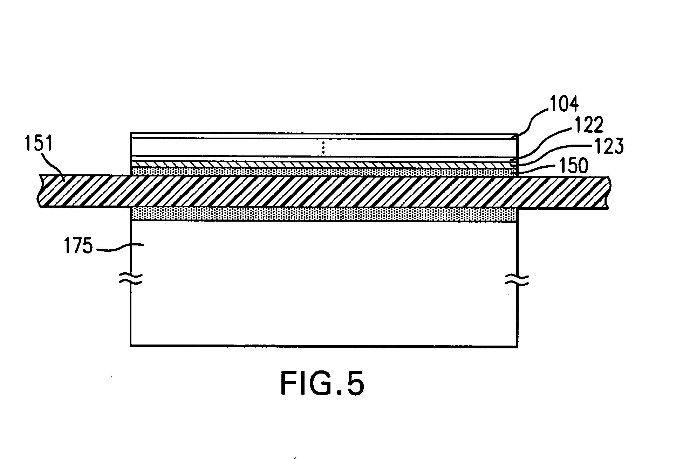

FIG. 5 is a cross-sectional view of the solar cell of FIG. 4 after the next process step according to the present invention of removing layer 103 from the top of the exposed semiconductor surface by known wet or dry chemical etching. Since 104 is an etch stop layer, the etching removes layer 103 entirely.

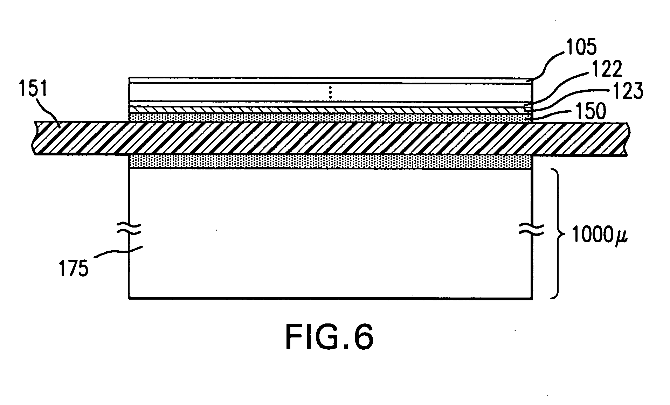

FIG. 6 is a cross-sectional view of the solar cell of FIG. 5 after the next process step according to the present invention in which the layer 104 of the semiconductor surface is removed, typically by a HCl/H₂O solution.

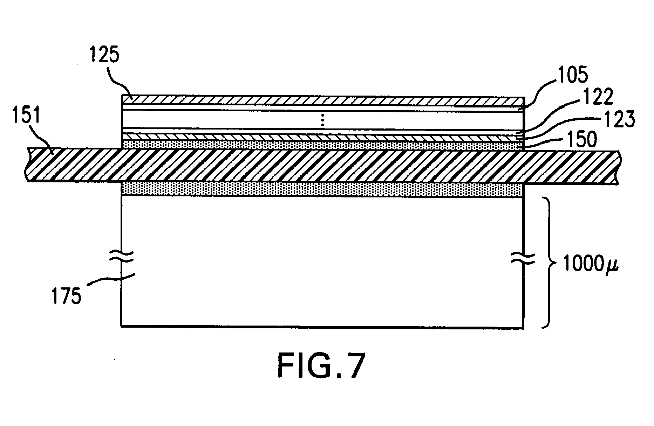

FIG. 7 is a cross-sectional view of the solar cell of FIG. 6 after the next process step according to the present invention. Lithography is first done to deposit photoresist to define regions where there will be no metal. A metal layer is evaporated over the photoresist. A metal layer 125 is typically composed of Pd/Ge/Ti/Pd/Ag/Au layers.

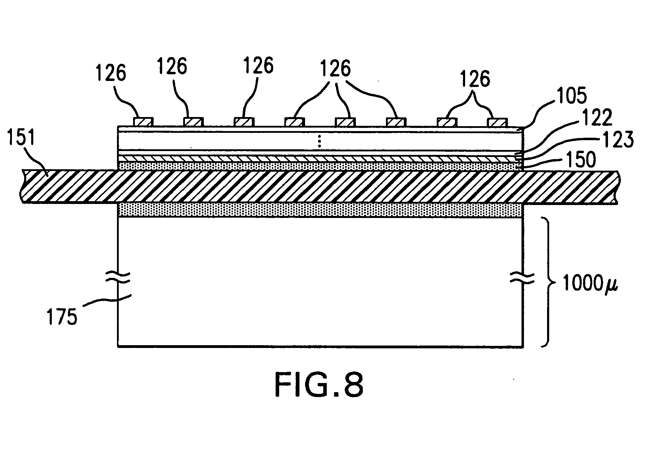

FIG. 8 is a cross-sectional view of the solar cell of FIG. 7 after the next process step according to the present invention in which the metal layer is patterned into grid lines by known lithographic techniques, in which portions of the metal layer 125 are lifted off so that the remaining metal forms parallel lines 126 which forms the grid on the front surface of the solar cell.

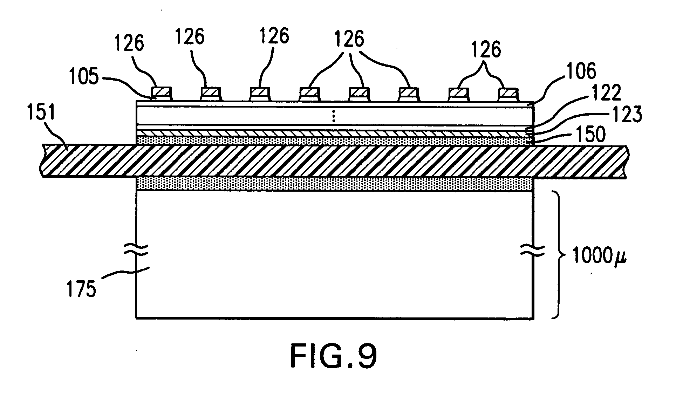

FIG. 9 is a cross-sectional view of the solar cell of FIG. 8 after the next process step according to the present invention in which the grid lines are used as a mask, and the cap layer 105 of the semiconductor structure between the grid lines is removed by known wet or dry chemical etching processes, thereby exposing the window layer 106 between the grid lines and over the rest of the exposed semiconductor surface.

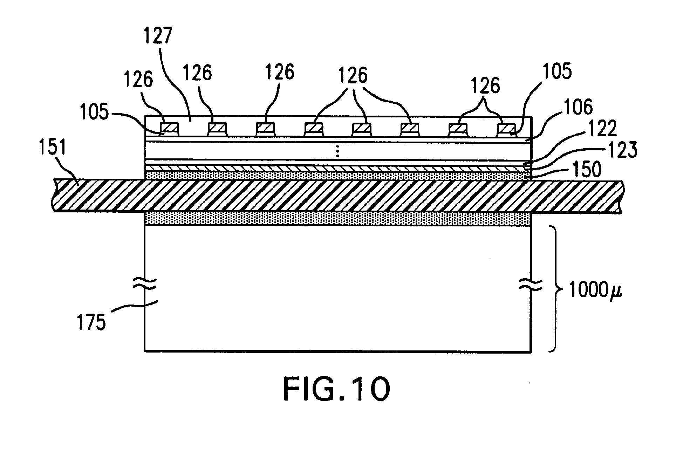

FIG. 10 is a cross-sectional view of the solar cell of FIG. 9 after the next process step according to the present invention in which an ARC layer is deposited to a thickness of about 2000 Angstroms over the top surface of the grid lines 126. A lithographic process is then used so that the ARC is removed from regions where bond pads are to be located

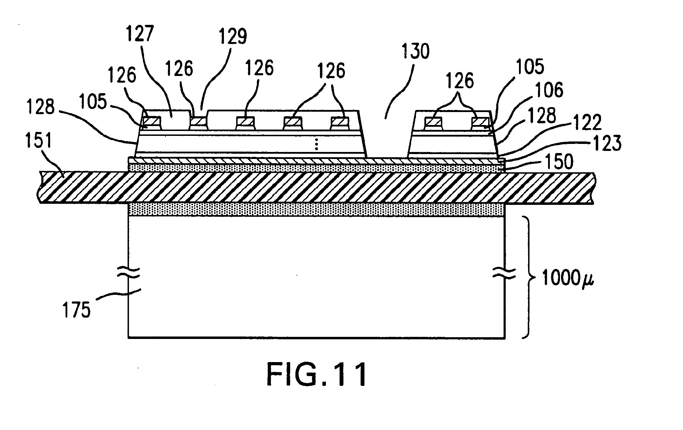

FIG. 11 is a cross-sectional view of the solar cell of FIG. 10 after the next process step according to the present invention in which the peripheral edges of the structure are etched down to the metal layer 123, thereby forming a mesa semiconductor structure on the surface of the wafer. Another lithographic process is then used to wet etch a back metal via from the top of the cell to the back metal. This allows contact to be made to the back metal or anode of the solar cell.

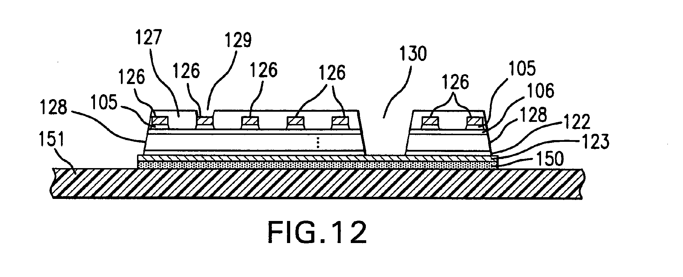

FIG. 12 is a cross-sectional view of the solar cell of FIG. 11 after the next process step according to the present invention in which the surrogate substrate is removed.

Although the present invention has been described above in a specific preferred embodiment as a process for making a certain type of solar cell, more generally the invention is simply a method of bonding a wafer (with or without device structure or layers) face down on a relatively thin flexible film (such as Kapton from Du Pont), using an appropriate adhesive (such as Teflon (FFP/PFA), or polyimide from Du Pont), then thinning the wafer (grinding / lapping and etching) till the desired thickness is reached or the desired layers are reached, and then further processing the thin wafer further to make electronic, optical, or mechanical devices (for example, thin photovoltaic cells).

The invention also more generally includes using a rigid carrier (such as sapphire) to support the thin semiconductor structure or wafer on flexible thin film, through all the semiconductor device definition and processing, then the film can be demounted from the rigid substrate, and then applied to the final surface (for example, a solar panel). The film can be attached to the carrier using a temporary adhesive (such as I-4010 from Dow Corning).

Thinning the substrate means that some other means of support has to be given to the device layers, during the processing, and in use. Kapton is a good material, since it is heat and chemically resistant, and also it is flexible. It can be obtained in different thicknesses, and can be obtained with adhesives on one or both sides. Adhesives such as Teflon are available on Kapton, which is suitable for this purpose, since Teflon is very chemically resistant, and also is heat resistant to a certain degree. Alternatively, adhesive can be applied (by lamination, or spinning on, for example). Teflon sheets can be laminated onto Kapton. Polyimide can be spun onto the wafer and the wafer can be attached to Kapton using the polymide as an adhesive. Adhesives can also be applied to Kapton, at the end of the process, to attach it to curved or flat surfaces temporarily or permanently.

As described above, one embodiment of the present invention comprises attaching wafers face down onto a film such as Kapton, using adhesives such as Teflon or polyimide, attaching a rigid carrier if needed, thinning the wafers, processing the devices, demounting from the rigid carrier (if used), and then applying the devices on Kapton to the final surface, with or without another adhesive.

FEP and PFA are Du Pont varieties of Teflon and are thermoplastics that can also be used as adhesives. PFA (300-310C) is higher melting than FEP (250-280C). PFA can be subject to 260C continuous use, and FEP can be subject to 205C continuous use. Both of these are available in films of various thicknesses.

Kapton is a polyimide from Du Pont, available in various thicknesses, and with FEP or PFA already laminated to it. Alternatively, FEP and/or PFA can be applied to Kapton films by laminating in a hot platen press.

There are two ways, depending on whether the Kapton has FEP/PFA on one or both sides. If the polymer is only on one side, another adhesive, such as Dow Coming I-4010, can be used on the other side, if the wafer/Kapton combination has to be attached to a rigid carrier, for support while processing, for example during lithography.

In the embodiment using double sided FEP/Kapton or PFA/Kapton, the starting point would be the wafer with any needed device layers. For the specific case of making thin inverted photovoltaics, the wafer can then be metallized on the device side, and annealed, if needed.

If a rigid carrier is needed during processing, mate the wafer (device side down) and the carrier (for example, a sapphire disc/Si wafer) on either side of the Kapton, in a hot platen press. The press applies a combination of heat and pressure. The FEP/PFA is melted under pressure, to make a continuous bond. Upon cooling and removal of pressure, after a prescribed time, the wafer (device side down), the Kapton, and the carrier (sapphire/Si), will be attached to each other.

Thin (grinding, lapping and/or etching) the bulk of the wafer, to reach an etch stop, and/or the device layers (if any), and further process the wafer (standard device fab processes). For the specific case of the thin inverted photovoltaic, these processes might include, and not be restricted to, lithography, metallizations, depositions, etching, etc. The cell(s) on the wafer can be tested at this stage, by contacting the back metal from the front side through suitably etched contact windows. and also front contact pads.

Detach the Kapton from the carrier by heating up to the melting point of the thermoplastic. This can be done on a hot plate, for example. When the polymer between the carrier and the Kapton melts, the Kapton with the thinned wafer on it can be pulled off. There might be some melting of the polymer between the Kapton and the wafer, but this will re-solidify when the Kapton is taken off the carrier. There shouldn't be any detachment of the IMM wafer / cells from the Kapton. Ideally, Kapton with PFA on the wafer side, and FEP on the carrier side, should be used, in which case, heating up to the FEP melting temperature would release the Kapton / wafer from the carrier, leaving the PFA bond between the Kapton and the wafer intact, as PFA melts higher than FEP.

The devices are now on Kapton, ready for further connection. Cutting the Kapton mechanically, through etched streets on the wafer, if needed, can separate them. A cover glass can be attached. For the specific case of photovoltaics, the mesa streets can be used to cut through the Kapton, if the cells need to be separated, and the cells can be interconnected. The Kapton can be attached to a final flat or curved surface, with or without adhesive (for example, a solar panel), as the devices will be thin enough (microns) to be flexible.

In the embodiment using single sided FEP / Kapton or PFA / Kapton, in which a rigid carrier could be used during processing, another adhesive, for example Dow Coming I-4010, can be used to attach the Kapton to the rigid carrier, which may be for example a sapphire substrate with holes as previously noted. This is done in commercially available wafer equipment that applies a combination of vacuum, pressure, and heat to cure the adhesive. This can be done after the Kapton / FEP or the Kapton /PFA is attached to the wafer in the hot platen press. I-4010 is a silicone adhesive that is inert to many solvents, acids, bases and other chemicals used in wafer fab. It is also heat resistant.

After processing, as before, the carrier used has to be debonded by a solvent. The holes in the sapphire help to speed up the debonding, by increasing access of the solvent to the adhesive. The FEP / PFA bond is inert to this solvent, and therefore the Kapton / wafer bond will remain intact after demounting from the sapphire. Just as before, the wafer bonded to Kapton can be cut mechanically to separate the devices, for further processing.

Other adhesives: Instead of FEP / PFA, we can also use any other adhesive that is resistant to the temperatures, chemicals, and other environment that's involved in the processing and final application of the devices. One chemically and thermally resistant material that can be used is polyimide, of which a variety is available, with different cure temperatures and environmental resistance. This can be applied by, for example, spin coating, to the wafer backside, the Kapton can be attached, and the stack cured to make the bond. After which the procedure is the same as above.

## Claims

1. A method of manufacturing a solar cell comprising:
providing a substrate;
depositing on a first substrate a sequence of layers of semiconductor material forming a solar cell;
mounting a semiconductor substrate on a flexible film; and
thinning the semiconductor substrate to a predetermined thickness.

2. A method as defined in claim 1, wherein the sequence of layers of semiconductor material is mounted directly adjacent to the flexible film.

3. A method as defined in claim 1, further comprising attaching the flexible film to a surrogate substrate.

4. A method as defined in claim 3, wherein the surrogate substrate is a sapphire wafer.

5. A method as defined in claim 4, further comprising removing said surrogate substrate subsequent to processing.

6. A method as defined in claim 5, further comprising attaching said solar cell with said flexible film to a glass supporting member.

7. A method as defined in claim 1, wherein said step of depositing a sequence of layers of semiconductor material includes forming a first solar subcell on said substrate having a first band gap; forming a second solar subcell over said first subcell having a second band gap smaller than said first band gap; forming a grading interlayer over said second subcell having a third band gap larger than said second band gap; forming a third solar subcell having a fourth band gap smaller than said second band gap such that said third subcell is lattice mis-matched with respect to said second subcell.

8. A method of manufacturing a solar cell as defined in claim 1, wherein said first substrate is composed of GaAs, said first solar subcell is composed of an InGa(Al)P emitter region and an InGa(A1)P base region, said second solar subcell is composed of an InGaP emitter region and an In_{0.015}GaAs base region.

9. A method of manufacturing a solar cell as defined in claim 7, wherein the grading interlayer is composed of a plurality of layers of InGaAlAswith monotonically increasing lattice constant.

10. A solar cell comprising:
a flexible film;
a semiconductor body mounted on said film, and having a sequence of layers:
including a first solar subcell having a first band gap;
a second solar subcell disposed over the first subcell and having a second band gap smaller than the first band gap;
a grading interlayer disposed over the second subcell having a third band gap larger than the second band gap; and
a third subcell disposed over the interlayer such that the third solar subcell is lattice mis-matched with respect to the second subcell and has a fourth band gap smaller than the third band gap.
